# EUROPEAN PATENT APPLICATION

(11) **EP 1 816 470 A1**
(43) Date of publication of application: **08.08.2007**
(21) Application number: 07250449.1
(22) Date of filing: 02.02.2007
(51) Int. Cl.: G01N 27/20, H01L 23/373

(54) **Method of inspecting laminated assembly and method of inspecting heat spreader module**

(30) Priority: 03.02.2006 JP 2006027382
(71) Applicant: NGK INSULATORS, LTD., Nagoya-shi, Aichi 467-8530 (JP)
(72) Inventor: Ishikawa Shuhei c/o Legal Affairs and Intellectual, Aichi-ken, 467-8530 (JP); Kuno, Yumihiko c/o Legal Affairs and Intellectual, Aichi-ken, 467-8530 (JP); Nakayama, Nobuaki c/o Legal Affairs & Intellectual, Aichi-ken, 467-8530 (JP); Ishihara, Toshiaki c/o Legal Affairs &Intellectual, Aichi-ken, 467-8530 (JP)
(74) Representative: Brasnett, Adrian Hugh

(57) **Abstract**

A heat spreader module (10) includes a laminated assembly (12), a heat spreader (16) bonded to an upper surface of the laminated assembly (12), and a circuit board (18) bonded to an upper surface of the heat spreader (16). The laminated assembly (12) includes a base (20), an insulated substrate (22) bonded to an upper surface of the base (20), and an intermediate metal plate (24) bonded to an upper surface of the insulated substrate (22). A nonwoven fabric (72) impregnated with a liquid is prepared, and an exposed portion (22a) of the insulated substrate (22), which extends out from below the intermediate metal plate (24), is wiped with the nonwoven fabric (72). Then, the entire structure is dried until the liquid on the exposed portion (22a) of the insulated substrate (22) is removed. Thereafter, a pulsed voltage is applied between the circuit board (18) and the base (20).

## Description

### BACKGROUND OF THE INVENTION

### Field of the Invention:

The present invention relates to a method of inspecting a heat spreader module for cooling an IC chip, which comprises a laminated assembly or a semiconductor having an insulated substrate sandwiched between two metal plates.

### Description of the Related Art:

Generally, heat spreader modules including a laminated assembly, to be described below, are used as devices for effectively dissipating the heat of a semiconductor circuit, such as an IGBT (Insulated Gate Bipolar Transistor) or the like.

The laminated assembly comprises a base of metal, an insulated substrate bonded to an upper surface of the base, and a circuit board bonded to an upper surface of the insulated substrate. The base and the circuit board are made of aluminum or copper, and the insulated substrate is made of aluminum nitride (AlN), silicon nitride (Si₃N₄), or the like.

There has been disclosed and put to practical use a method of joining a circuit board, an insulated substrate, and a base with a hard brazing material under pressure in one step, without allowing a bonding layer, which tends to impose heat resistance, to remain unremoved in the assembly. The method makes it possible to produce an inexpensive heat spreader module with high thermal conductivity (see, for example, Japanese Laid-Open Patent Publication No. 2002-43482 and Japanese Laid-Open Patent Publication No. 2004-253736).

For effectively operating a semiconductor circuit that is mounted on a heat spreader module, it is necessary that the laminated assembly making up the heat spreader module be electrically insulated.

Since the insulated substrate is brittle, it tends to crack rather than simply being deformed when it is subjected to stresses. If the insulated substrate cracks, it fails to provide a desired withstand voltage or a desired insulation resistance, possibly resulting in an accidental short circuit.

Heretofore, it has been customary to measure the laminated assembly for withstand voltage or insulation resistance under controlled low-humidity conditions (i.e., under dry conditions). Therefore, if the insulated substrate cracks, then since an air layer is present within the crack, when the measurement is performed, the laminated assembly is determined as having a desired withstand voltage or a desired insulation resistance due to the presence of the air layer.

Cracks in insulated substrates have also been detected by means of a visual check. However, visual inspection is disadvantageous in that it requires skilled inspectors, the visual checking needs to be continued for five minutes or longer for each product to be inspected, the inspection accuracy depends on the skill and fatigue of the inspector, and limitations are imposed on efforts to simplify the inspection process. Particularly, if the insulated substrate develops minute cracks therein, it is difficult to discover withstand voltage failures merely by means of visual inspection.

### SUMMARY OF THE INVENTION

It is an object of the present invention to provide a method of inspecting a laminated assembly including an insulated substrate, for easily discovering a withstand voltage failure even if the insulated substrate has developed one or more minute cracks therein, thereby increasing the inspection accuracy for the laminated assembly.

Another object of the present invention is to provide a method of inspecting a heat spreader module including a laminated assembly, for easily discovering failures in the withstand voltage of the heat spreader module, thereby increasing the inspection accuracy for the heat spreader module.

According to a first aspect of the present invention, there is provided a method of inspecting a laminated assembly having a first metal plate, a second metal plate, and an insulated substrate interposed between the first metal plate and the second metal plate, comprising the steps of coating an exposed portion of the insulated substrate with a liquid, drying the exposed portion which has been coated with the liquid, and then applying a voltage to the insulated substrate. The voltage is applied between two electrically conductive portions, which sandwich the insulated substrate therebetween.

If the insulated substrate of the laminated assembly has a crack therein, then when the exposed portion of the insulated substrate is coated with the liquid, the liquid seeps into the crack. When the coated portion of the insulated substrate is subsequently dried, the liquid that has entered the crack remains. The unremoved liquid remains within the crack even if the crack is a minute crack. Then, when the voltage is applied to the insulated substrate, current flows through the liquid that remains within the crack, thereby indicating that the withstand voltage of the insulated substrate has been lowered. Stated otherwise, application of voltage between the insulated substrate is effective to measure the withstand voltage of the laminated assembly or the insulation resistance of the laminated assembly.

Since only the exposed portion of the insulated substrate needs to be coated with liquid, and voltage is applied easily for measuring the withstand voltage (or the insulation resistance), the inspector requires no special skill. The time required to inspect one heat spreader module is at most about 30 seconds. Therefore, the inspecting method is simple, short, and inexpensive to perform. Insulated substrates with cracks therein can be detected with 100% accuracy, irrespective of the skill or fatigue of the inspector, so that inspection accuracy is greatly increased.

If the insulated substrate is free of cracks, then since no liquid remains within the insulated substrate, the insulated substrate provides a desired withstand voltage and a desired insulation resistance.

Therefore, even if the insulated substrate of the laminated assembly contains one or more minute cracks therein, a withstand voltage failure thereof can easily be discovered. Therefore, inspection accuracy of the laminated assembly is increased. Such increased inspection accuracy is highly effective in order to increase the reliability of the withstand voltage and insulation resistance of the laminated assembly.

In the first aspect of the present invention, the step of coating the exposed portion may further comprise the step of wiping the exposed portion with a nonwoven fabric impregnated with the liquid. Using such a nonwoven fabric, since it is low in cost, allows the exposed portion to be easily coated with the liquid inexpensively.

In the first aspect of the present invention, the insulated substrate should preferably have an area that is greater than an area of at least the first metal plate. Therefore, the exposed portion of the insulated substrate is relatively large and can easily be coated with the liquid.

In the first aspect of the present invention, the liquid should preferably have a wetting angle of 90° or smaller with respect to the insulated substrate. If the insulated substrate has a crack therein, then the liquid with such a wetting angle finds it easy to enter into the crack. Consequently, the liquid can sufficiently seep into the crack even if the crack is a minute crack.

In the first aspect of the present invention, the liquid may comprise an organic compound or water. If the liquid comprises an organic compound, then the organic compound may comprise alcohol, phenol, ether, aldehyde, ketone, carboxylic acid, amine, or any of derivatives thereof. If the liquid comprises water, then it may comprise tap water, which is inexpensive.

According to a second aspect of the present invention, there is provided a method of inspecting a heat spreader module having a laminated assembly comprising a first metal plate, a second metal plate, and an insulated substrate interposed between the first metal plate and the second metal plate, and further wherein a heat spreader is mounted on the laminated assembly, comprising the steps of coating an exposed portion of the insulated substrate with a liquid, drying the exposed portion which has been coated with the liquid, and applying a voltage to the insulated substrate.

The above method makes it easy to discover a withstand voltage failure of the heat spreader module. The inspection accuracy for the heat spreader module is thus increased. The increased inspection accuracy is highly effective to increase reliability of the withstand voltage and insulation resistance of the heat spreader module.

If the first metal plate comprises an intermediate metal plate and the second metal plate comprises a base of metal, then the heat spreader module may include the insulated substrate, the intermediate metal plate, the heat spreader, and a circuit board with a semiconductor circuit mounted thereon, which are bonded successively in the order named onto the base.

If the first metal plate comprises a circuit board with a semiconductor circuit mounted thereon and the second metal plate comprises an intermediate metal plate, then the heat spreader module may include the intermediate metal plate, the insulated substrate, and the circuit board, which are bonded successively in the order named onto the heat spreader.

In the second aspect of the present invention, the voltage may be applied to the insulated substrate in order to measure a withstand voltage of the heat spreader module or the insulation resistance of the heat spreader module.

In the second aspect of the present invention, the step of coating the exposed portion may further comprise the step of wiping the exposed portion with a nonwoven fabric impregnated with the liquid.

In the second aspect of the present invention, the insulated substrate may have an area that is greater than an area of at least the first metal plate.

In the second aspect of the present invention, the liquid should preferably have a wetting angle of 90° or smaller with respect to the insulated substrate.

In the second aspect of the present invention, the liquid may comprise an organic compound. The organic compound may comprise alcohol, phenol, ether, aldehyde, ketone, carboxylic acid, amine, or any of derivatives thereof.

In the second aspect of the present invention, the liquid may comprise water.

In the first and second aspects of the present invention, the insulated substrate may be made of silicon nitride (Si₃N₄), aluminum nitride (AlN), aluminum oxide (Al₂O₃), silicon carbide (SiC), beryllium oxide (BeO), or boron nitride (BN).

In the second aspect of the present invention, the heat spreader may be made of copper (Cu), a Cu alloy, aluminum (Al), an Al alloy, nickel (Ni), a Ni alloy, tungsten (W), or molybdenum (Mo).

In the second aspect of the present invention, the heat spreader may be made of a composite material, e.g., a composite material of carbon (C) and a metal material. The metal material may be Cu, a Cu alloy, Al, or an Al alloy. In the composite material, Si₃N₄, AlN, Al₂O₃, SiC, BeO, or BN may be used instead of carbon.

Even if a hard brazing material is used as a bonding material to bond the components of the heat spreader module, since the offset yield strength of the base is kept at or above a certain level after the components have been bonded together, the heat spreader module is prevented from becoming deformed when handled, and further, the thermal conductivity of the heat spreader module is prevented from being lowered.

The above and other objects, features, and advantages of the present invention will become more apparent from the following description when taken in conjunction with the accompanying drawings in which preferred embodiments of the present invention are shown by way of illustrative example.

### BRIEF DESCRIPTION OF THE DRAWINGS

FIG. 1 is a vertical cross-sectional view of a heat spreader module for use in the present invention;
FIG. 2 is an enlarged fragmentary view of an SiC/Cu composite material for use as an example of a constituent of a heat spreader;
FIG. 3 is an enlarged fragmentary view of another SiC/Cu composite material for use as an example of a constituent of a heat spreader;
FIG. 4 is a flowchart of an operation sequence of a manufacturing process, including an inspecting method, according to the present invention;
FIG. 5 is a vertical cross-sectional view illustrating a setting step;
FIG. 6 is a vertical cross-sectional view illustrating a joining step;
FIG. 7 is a vertical cross-sectional view illustrating a liquid applying step;
FIG. 8 is a vertical cross-sectional view illustrating a voltage applying step; and
FIG. 9 is a vertical cross-sectional view of a modified heat spreader module for use in the present invention.

### DESCRIPTION OF THE PREFERRED EMBODIMENTS

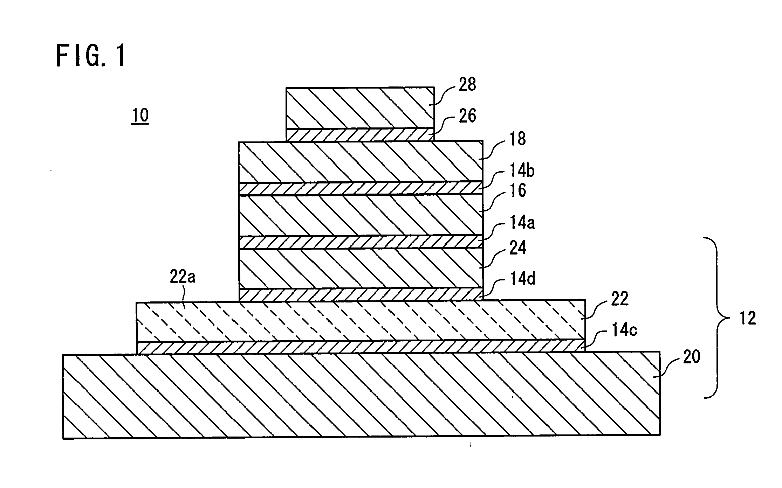

A method of inspecting a laminated assembly and a method of inspecting a heat spreader module according to embodiments of the present invention shall be described below with reference to FIGS. 1 through 9.

As shown in FIG. 1, a heat spreader module 1 for use in the present invention comprises a laminated assembly 12, a heat spreader 16 bonded to an upper surface of the laminated assembly 12 by a first brazing layer 14a, and a circuit board 18 bonded to an upper surface of the heat spreader 16 by a second brazing layer 14b.

The laminated assembly 12 includes a base 20, an insulated substrate 22 bonded to an upper surface of the base 20 by a third brazing layer 14c, and an intermediate metal plate 24 bonded to an upper surface of the insulated substrate 22 by a fourth brazing layer 14d.

A semiconductor circuit (IC chip) 28, such as an IGBT or the like, is bonded to an upper surface of the circuit board 18 by a solder layer 26. A heat sink, not shown, which serves as a heat radiator and is made of Al (aluminum) or Cu (copper), is fastened to a lower surface of the base 20 by screws or the like.

The heat spreader 16 possesses a thermal conductivity, which preferably is of 150 W/mK or higher. If the thermal conductivity is lower than 150 W/mK, then when the heat spreader module 10 is placed in operation, the rate at which the heat spreader 16 transfers heat generated by the IC chip 28 outside of the heat spreader module 10 is so low that the heat spreader module 10 cannot be kept at a constant temperature.

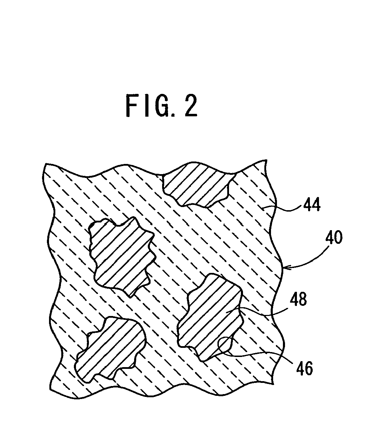

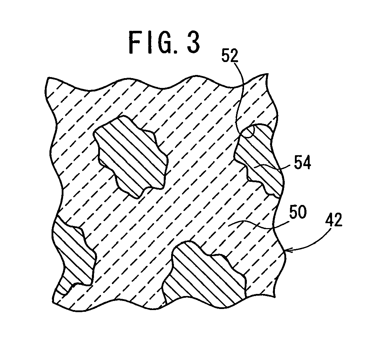

The heat spreader 16 is made of at least one material selected from the group consisting of SiC, AlN, Si₃N₄, BeO, Al₂O₃, Be₂C, C, Cu, a Cu alloy, Al, an Al alloy, Ag, an Ag alloy, and Si. Specifically, the heat spreader 16 may be made of a single material selected from the above group, or a composite material including two or more materials selected from the above group. Composite materials that can be used to make up the heat spreader 16 include, for example, an SiC/Cu composite material 40 (see FIG. 2), and a C/Cu composite material 42 (see FIG. 3).

As shown in FIG. 2, the SiC/Cu composite material 40 is produced by impregnating pores 46 formed in a SiC porous sintered body 44 with a molten Cu or Cu alloy 48, and then solidifying the Cu or Cu alloy 48.

As shown in FIG. 3, the C/Cu composite material 42 is produced by impregnating pores 52 in a porous sintered body 50, which is obtained by prebaking carbon or an allotrope thereof into a network structure, along with a Cu or Cu alloy 54, and then solidifying the Cu or Cu alloy 54. Such a C/Cu composite material 42 is disclosed in Japanese Laid-Open Patent Publication No. 2001-339022, for example.

If the heat spreader 16 is made of a composite material or an alloy, its coefficient of thermal expansion can be controlled so as to reside within a range from 3.0 × 10⁻⁶ to 1.0 × 10⁻⁵/K, whereas the thermal conductivity can be controlled so as to reside within a range of 150 W/mK or greater, respectively, by setting the elemental ratios of the composite material or the alloy.

The base 20 of the laminated assembly 12 may be made of copper (Cu), a copper alloy (Cu alloy), aluminum (Al), an aluminum alloy (Al alloy), molybdenum (Mo), a molybdenum alloy (Mo alloy), tungsten (W), or a tungsten alloy (W alloy). Particularly, the base 20 may be made of a Cu alloy having a thermal conductivity of 270 W/mK or higher, and an offset yield strength of 45 MPa or higher, which are achieved after the alloy has been heated at a temperature in the range from 600 to 900 °C for 10 minutes.

The Cu alloy of the base 20 should preferably be one of:
(a) a Cu alloy comprising 0.1 to 1.5 weight % of chromium (Cr) and the remainder of which is Cu;
(b) a Cu alloy comprising 0.1 to 0.5 weight % of zirconia (Zr) and the remainder of which is Cu;
(c) a Cu alloy comprising 0.05 to 0.3 weight % of Zr, 0.3 to 1.2 weight % of Cr, and the remainder of which is Cu;
(d) a Cu alloy comprising 0.01 to 1.5 weight % of silver (Ag) and the remainder of which is Cu;
(e) a Cu alloy comprising 1.4 to 3.0 weight % of iron (Fe), 0.05 to 0.2 weight % of zinc (Zn), 0.01 to 0.1 weight % of phosphorus (P), and the remainder of which is Cu; and
(f) alumina-dispersed copper.

The base 20 should preferably have a thickness of 0.1 mm or greater. Further, the thickness of the base 20 should preferably be 40 % or less of the overall thickness of the heat spreader module 10.

The insulated substrate 22 of the laminated assembly 12 may be made of Si₃N₄, AlN, Al₂O₃, SiC, BeO, or BN. According to the illustrated embodiment, the area of the insulated substrate 22 is greater than the area of the intermediate metal plate 24, and smaller than the area of the base 20. Therefore, the insulated substrate 22 has an exposed portion 22a that extends outward from below the intermediate metal plate 24.

The intermediate metal plate 24 of the laminated assembly 12 may be made of Cu, a Cu alloy, Al, or an Al alloy.

The first brazing layer 14a, the second brazing layer 14b, the third brazing layer 14c, and the fourth brazing layer 14d should preferably be made of a hard brazing material including an active element. The active element may be at least one of elements belonging to Group 2A of the periodic table, e.g., Mg, Sr, Ca, Ba, Be, etc., elements belonging to Group 3A of the periodic table, e.g., Ce, etc., elements belonging to Group 4A of the periodic table, e.g., T, Zr, etc., or elements belonging to Group 5A of the periodic table, e.g., Nb, etc., and elements belonging to Group 4B of the periodic table, e.g., B, Si, etc. In the illustrated embodiment, the first brazing layer 14a, the second brazing layer 14b, the third brazing layer 14c, and the fourth brazing layer 14d are made of a hard brazing material of Ag-Cu-Ti, or a hard brazing material of Ag-Cu-In-Ti, wherein the active element is Ti.

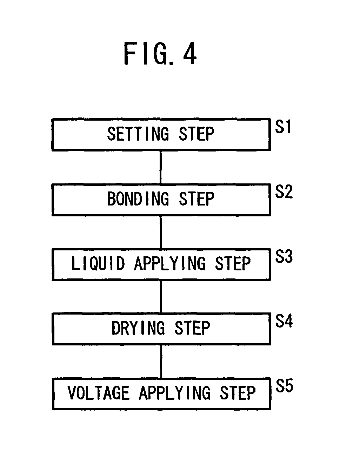

A process for manufacturing the heat spreader module 10, which includes an inspecting method according to the present invention, shall be described below with reference to FIGS. 4 through 8.

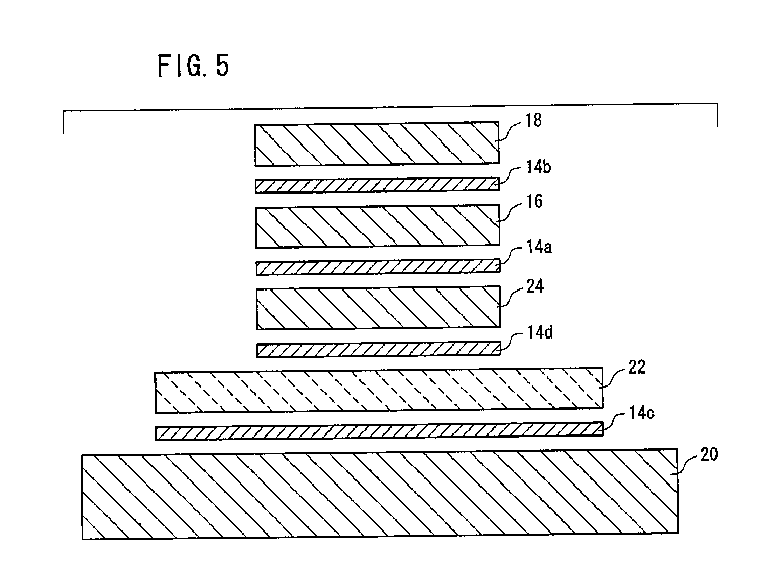

In the setting step S1, as shown in FIG. 4, the third brazing layer 14c, the insulated substrate 22, the fourth brazing layer 14d, the intermediate metal plate 24, the first brazing layer 14a, the heat spreader 16, the second brazing layer 14b, and the circuit board 18 are placed (set) successively in the order named onto the base 20, as shown in FIG. 5. The setting step S1 is carried out in the atmosphere, for example.

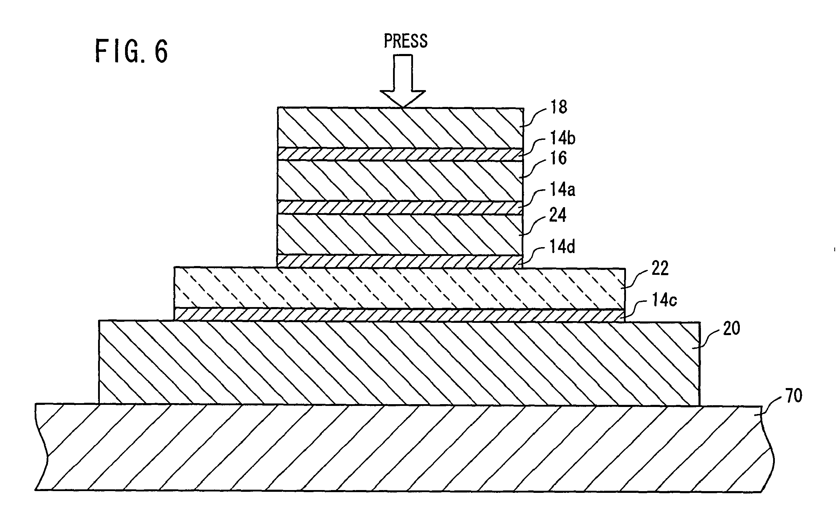

In the bonding step S2, as shown in FIG. 4, the base 20, on which the third brazing layer 14c, the insulated substrate 22, the fourth brazing layer 14d, the intermediate metal plate 24, the first brazing layer 14a, the heat spreader 16, the second brazing layer 14b, and the circuit board 18 have been set, is fixedly mounted on a jig 70 (see FIG. 6). While the assembly is pressed downwardly in a vacuum of 1.0 × 10⁻⁵ Torr or lower, the temperature thereof is increased and then reduced in order to bond the components of the assembly, thereby producing a bonded structure (i.e., the heat spreader module 10), wherein the laminated assembly 12 (the base 20, the insulated substrate 22, and the intermediate metal plate 24), the heat spreader 16, and the circuit board 18 are integrally combined together. The components may be bonded together while placed in a hydrogen atmosphere or an inactive gas atmosphere, and may be pressed under a selected load.

For controlling the thicknesses of the first brazing layer 14a, the second brazing layer 14b, the third brazing layer 14c, and the fourth brazing layer 14d, they should preferably be pressed under a pressure ranging from 0.05 MPa to 10 MPa. After the first brazing layer 14a, the second brazing layer 14b, the third brazing layer 14c, and the fourth brazing layer 14d have been bonded in the above pressure range, their average thickness is 50 µm or less, preferably 10 µm or less, or more preferably 5 µm or less. The average thickness is controllable by means of the applied pressure.

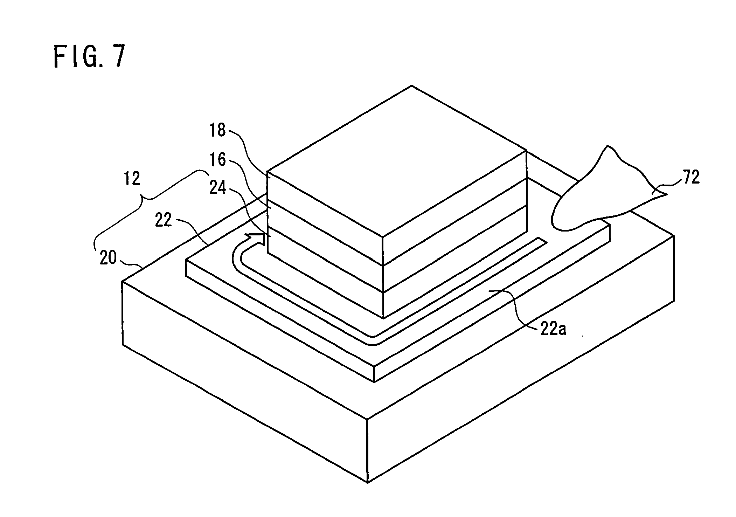

Thereafter, during the liquid applying step S3, as shown in FIG. 4, a nonwoven fabric 72 impregnated with a liquid is prepared as shown in FIG. 7, and the exposed portion 22a of the insulated substrate 22, which extends outward from below the intermediate metal plate 24, is wiped with the nonwoven fabric 72.

At this time, if the insulated substrate 22 has one or more cracks therein, the liquid seeps from the nonwoven fabric 72 into the crack.

Thereafter, in the drying step S4, as shown in FIG. 4, the assembly is dried until the liquid on the exposed portion 22a of the insulated substrate 22 has been removed. The exposed portion 22a that was coated with liquid is dried, however, the liquid that has entered the crack remains within the crack in an unremoved state. The unremoved liquid remains within the crack, even if the crack is a minute crack.

The liquid should preferably be a liquid having a wetting angle of 90° or smaller with respect to the insulated substrate 22. If the insulated substrate 22 has a crack therein, then liquid with such a wetting angle easily enters into the crack. Consequently, the liquid can seep sufficiently into the crack, even if the crack is a minute crack.

The liquid may be an organic compound or water. If the liquid is an organic compound, then the liquid may be alcohol, phenol, ether, aldehyde, ketone, carboxylic acid, amine, or any of derivatives thereof. If the liquid is water, then inexpensive tap water may be used.

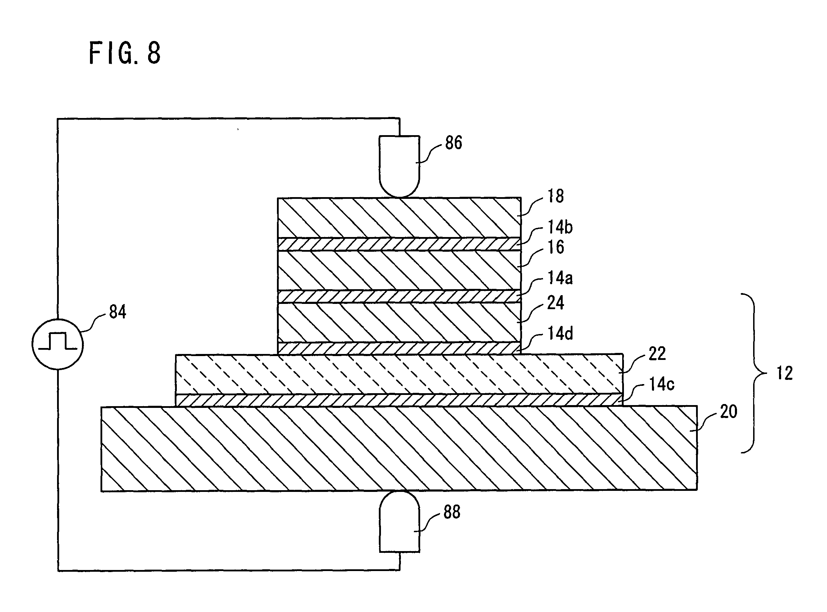

Thereafter, in the voltage applying step S5, as shown in FIG. 4, a voltage is applied to the insulated substrate 22. Specifically, as shown in FIG. 8, a pulsed power supply 84 has a first electrode 86 held in contact with the upper surface of the circuit board 18, and a second electrode 88 held in contact with the lower surface of the base 20. Then, the pulsed power supply 84 applies an AC or a DC pulsed voltage of 500 V between the first electrode 86 and the second electrode 88. The first electrode 86 is held against the intermediate metal plate 24 and the second electrode 88 is held against the base 20, and thereafter, the pulsed voltage is applied between the first and second electrodes 86, 88.

When the pulsed voltage is applied between the circuit board 18 and the base 20, or between the intermediate metal plate 24 and the base 20, a current flows through the liquid that remains within the crack in the insulated substrate 22, which indicates that the withstand voltage of the insulated substrate 22 has been lowered.

Stated otherwise, application of the pulsed voltage between the circuit board 18 and the base 20, or between the intermediate metal plate 24 and the base 20, is effective to measure the withstand voltage (or insulation resistance) of the laminated assembly 12 or the heat spreader module 10.

Since only the exposed portion 22a of the insulated substrate 22 needs to be coated with liquid, and a pulsed voltage is simply applied for measuring the withstand voltage (or the insulation resistance), the inspector requires no special skill. The time required to inspect one heat spreader module is at most about 30 seconds.
Therefore, the inspecting method is simple, short, and inexpensive to perform. Insulated substrates 22 having cracks therein can be detected with 100% reliability, irrespective of the skill or fatigue of the inspector, whereby inspection accuracy is greatly increased.

If the insulated substrate 22 is free of cracks, then since no unremoved liquid remains within the insulated substrate 22, it provides a desired withstand voltage or a desired insulation resistance. The desired insulation resistance may be 1 × 10¹¹ ohms or higher, and preferably, should range from 5 × 10⁻¹¹ to 1 × 10¹² ohms.

According to the illustrated embodiment, therefore, even if the insulated substrate 22 of the laminated assembly 12 contains one or more minute cracks therein, a withstand voltage failure thereof can easily be discovered.
Therefore, the inspection accuracy for the laminated assembly 12 or the heat spreader module 10 is increased. Such increased inspection accuracy is highly effective to increase reliability of the withstand voltage and insulation resistance of the laminated assembly 12 or the heat spreader module 10.

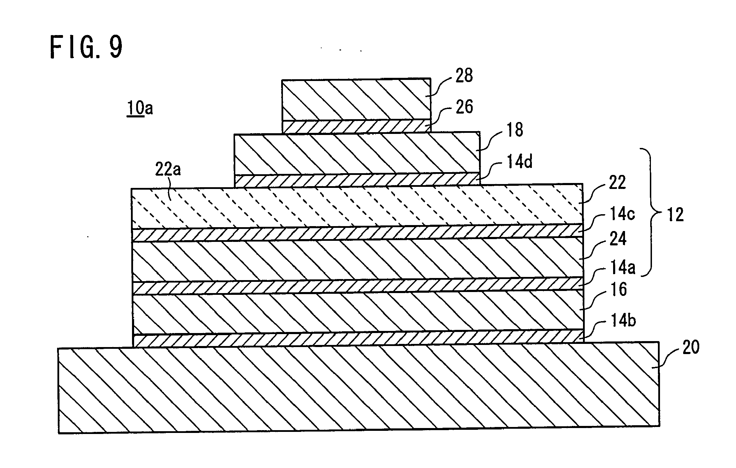

In the above embodiment, the heat spreader module 10 is formed in accordance with the structure shown in FIG. 1. However, a modified heat spreader module 10a, as shown in FIG. 9, may also be inspected according to the present invention.

As shown in FIG. 9, the modified heat spreader module 10a comprises a laminated assembly 12, a heat spreader 16 bonded to a lower surface of the laminated assembly 12 by a first brazing layer 14a, and a base 20 bonded to a lower surface of the heat spreader 16 by a second brazing layer 14b.

The laminated assembly 12 includes an intermediate metal plate 24, an insulated substrate 22 bonded to an upper surface of the intermediate metal plate 24 by a third brazing layer 14c, and a circuit board 18 bonded to an upper surface of the insulated substrate 22 by a fourth brazing layer 14d.

The modified heat spreader module 10a is inspected as follows. An exposed portion 22a of the insulated substrate 22 is coated with a liquid and then dried. Thereafter, a pulsed voltage is applied between the circuit board 18 and the base 20, or between the circuit board 18 and the intermediate metal plate 24, in order to measure a withstand voltage or an insulation resistance of the laminated assembly 12 or the heat spreader module 10a.

## Claims

1. A method of inspecting a laminated assembly (12) having a first metal plate, a second metal plate, and an insulated substrate (22) interposed between the first metal plate and the second metal plate, comprising the steps of:
coating an exposed portion (22a) of said insulated substrate (22) with a liquid;
drying said exposed portion (22a) which has been coated with said liquid; and
applying a voltage to said insulated substrate (22).

2. A method according to claim 1, wherein the voltage is applied to said insulated substrate (22) in order to measure a withstand voltage of said laminated assembly (12).

3. A method according to claim 1, wherein the voltage is applied to said insulated substrate (22) in order to measure an insulation resistance of said laminated assembly (12).

4. A method according to any one of claims 1 to 3, wherein said step of coating said exposed portion (22a) comprises the step of wiping said exposed portion (22a) with a nonwoven fabric (72) impregnated with said liquid.

5. A method according to any one of claims 1 to 4, wherein said insulated substrate (22) has an area that is greater than an area of at least said first metal plate.

6. A method according to any one of claims 1 to 5, wherein said liquid has a wetting angle of 90° or smaller with respect to said insulated substrate (22).

7. A method according to any one of claims 1 to 6, wherein said liquid comprises an organic compound.

8. A method according to claim 7, wherein said organic compound comprises alcohol, phenol, ether, aldehyde, ketone, carboxylic acid, amine, or any of derivatives thereof.

9. A method according to any one of claims 1 to 6, wherein said liquid comprises water.

10. A method according to any one of claims 1 to 9 wherein said laminated assembly (12) is in a heat spreader module.

11. A method according to claim 10, wherein said first metal plate comprises an intermediate metal plate (24), said second metal plate comprises a base (20) of metal, and said heat spreader module (10) includes said insulated substrate (22), said intermediate metal plate (24), said heat spreader (16), and a circuit board (18) with a semiconductor circuit (28) mounted thereon, which are bonded successively in the order named onto said base (20).

12. A method according to claim 10, wherein said first metal plate comprises a circuit board (18) with a semiconductor circuit (28) mounted thereon, said second metal plate comprises an intermediate metal plate (24), and said heat spreader module (10) includes said intermediate metal plate (24), said insulated substrate (22), and said circuit board (18), which are bonded successively in the order named onto said heat spreader (16).
